# EUROPEAN PATENT SPECIFICATION

(11) **EP 2 453 375 B1**
(45) Date of publication and mention of the grant of the patent: **10.10.2012**
(21) Application number: 10380144.5
(22) Date of filing: 30.11.2010
(51) Int. Cl.: G06F 17/50, B62D 65/00, G01B 11/24, G05B 19/418, G07C 3/14, G06T 7/00, G06T 7/60

(54) **Control procedure of style line of motor vehicle components**
Kontrollverfahren für Stillinie von Motorfahrzeugkomponenten
Procédure de contrôle de ligne de style de composants de véhicule à moteur

(43) Date of publication of application: 16.05.2012
(73) Proprietor: Seat, S.A., 08760 Martorell, Barcelona (ES)
(72) Inventor: Tablas Ruiz, Francesc Xavier, 08760 Martorell Barcelona (ES); Lopez Ribera, Sergio, 08760 Martorell Barcelona (ES); Jimenez Martín, Pedro, 08760 Martorell Barcelona (ES); Gómez Ponce, Cristóbal José, 08760 Martorell Barcelona (ES)
(74) Representative: Carvajal y Urquijo, Isabel

(56) References cited:
- EP-A2- 1 785 940
- WO-A1-96/34251
- US-A1- 2010 053 191

## Description

### Field of the invention

The present invention refers to the field of motor vehicle parts manufacturing, and more specifically, to quality control processes of said parts.

### Background of the invention

Measuring characteristics of a product is disclosed, for example, in WO 9 634 251.

In the field of motor vehicle components manufacturing, there currently exist some problems regarding the perception of style lines and radius due to lack of continuity between the outer and inner elements, whether they are manufactured with the same technology or not, Produced by deviations in parts, for example between the bumper and the side or between the lid of the fuel tank inlet and the side.

There is a need for a process to control style lines and radius in order to guarantee the continuity between the different parts of the bodywork, and that said style lines and radius are within a specified range in the design phase, in order to ensure that the style lines and radius in production correspond to those approved in the project validation process.

With the present invention it is attained the creation of a process for the control of radius of any value (uniform lines) in all type of parts and with diverse geometrical complexity (style lines), which so far could only be attained on great radius and with components of little geometrical complexity with the tools and processes used nowadays. In this way, corrective decisions and actions can be taken regarding the process at any phase, guaranteeing the quality of the product.

### Description of the invention

The invention refers to a radius and style line control process of motor vehicle components, such as bodywork parts. The object of the present invention is to control on a typical style line section of a motor vehicle bodywork or interior components, the following values.
- Radius value.
- Dimension of the arc chord and the dispersion of its points of tangency.
- Relative and absolute position of the style line.

The present invention intends to obtain, on a set of areas of the vehicle to be measured, the deviations produced. The data obtained can also be used to fix limits of the allowances and deviations produced during the manufacturing process.

The control procedure comprises the features of claim 1.

The control procedure can additionally comprise:
- in the 3D model of the vehicle, obtaining for each control point:
   - a theoretical middle point of the chord, being the middle point of the theoretical points of tangency;
   - a theoretical middle point of the arc; being the central point of the arc;
- obtaining, from the real points of tangency, the real middle point of the chord;
- obtaining, from the real cylinder and the set of measuring points, the real middle point of the arc and the deviation thereof vis-à-vis the theoretical middle point.

The three-dimensional scanning of the components will be preferably performed by means of a laser scanner.

The search field is preferably determined as a cylindrical volume defined between a cylinder with radius R_{T}-D_{MAX} and a cylinder with radius R_{T}+D_{MAX}, where D_{MAX} is the greatest deviation in absolute value produced between the central section of the real geometry and the theoretical central section.

The control procedure can also comprise an optimization stage of the set of measuring points, in which said set of points is placed in an optimal position with respect to the geometry of the 3D model of the vehicle through the unlocking of degrees of freedom according to the angle formed by the cylinder axis and the reference axes of the vehicle.

The vehicle component can be a bodywork element or an interior component of the vehicle.

### Brief description of the drawings

The following is a brief description of a series of drawings which will help understand the invention better relating to an embodiment of said invention which is presented as a non-limiting example thereof.
Figures 1A, 1B, 2A and 2B are examples of the definition of control points on the vehicle bodywork, figures 1B and 2B showing the details of the transitions between elements of the bodywork.
Figures 3A, 3B, 3C and 3D represent a sectional example of the geometry of the bodywork on a defined control point.
Figures 4A and 4B show the generation of an auxiliary theoretical cylinder, within the process of defining the values of the control points.
Figures 5A, 5B, 5C, 5D, 5E and 5F show the measuring stage of the point cloud in the determined control points of the bodywork.

### Detailed description of the invention

The control process of radius and style lines comprises the following stages:
1. Definition of values (e.g. radius values) in the control points.
2. Measuring process in the control points.
3. Radius and position calculation process.

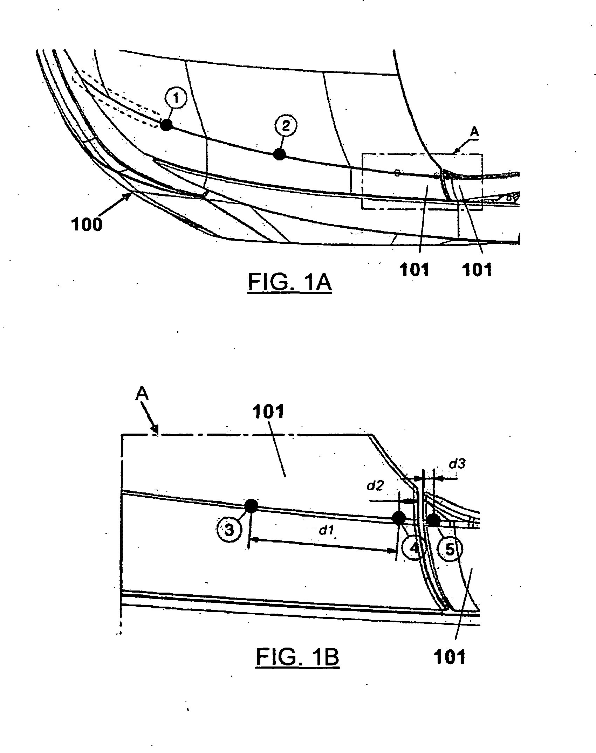

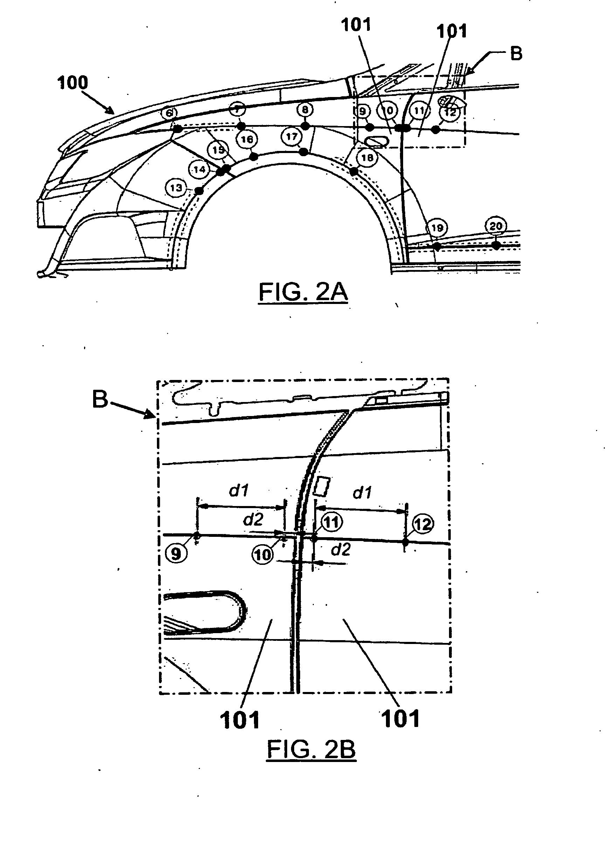

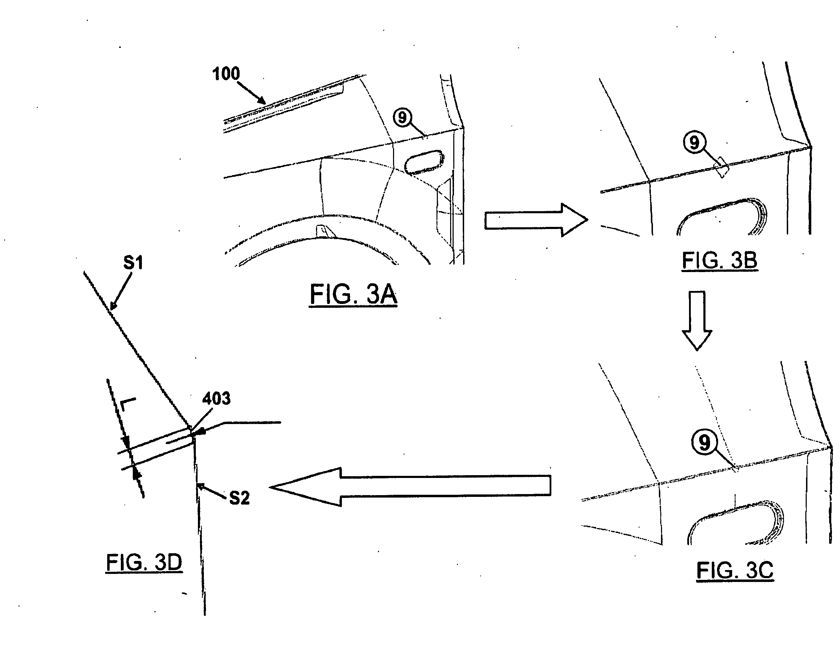

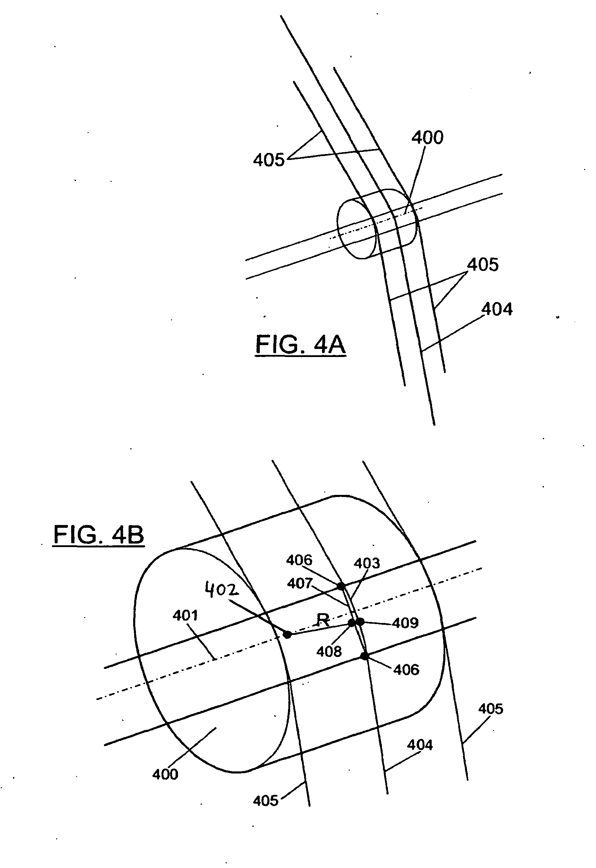

The first stage of definition of values in the control points in turn comprises the following stages:
- Defining the control points on the vehicle components 101 according to the geometry and characteristics of the vehicle model, as shown as an example in **Figures 1A** and **2A****,** particularly considering the transitions between different elements or parts of the bodywork (100), as shown in detail (details A and B) in the respective **Figures 1B** and **2B****,** particularly applying the continuity criterion between two consecutive components 101 of the bodywork (100). Said figures (1A, 1B, 2A and 2B) show the control points selected between circles (points 1, 2, 3, etc.), and the distances considered (d1, d2, d3) between control points or between control points and the edge of the part 101.
- Creating planes: sectioning of the geometry on points defined for the later extraction of theoretical data. **Figures 3A, 3B, 3C** and **3D** represent with arrows, as an example, the process of sectioning of the geometry of the component (101) of the bodywork through a central cutting plane perpendicular to the bodywork at the control point number 9, from which the radius of curvature R and the length of the chord L of the arc 403 of its points of tangency will be obtained. Figure 3D represents the surfaces (S1, S2) of the bodywork tangent to the arc 403.
- Creating auxiliary geometry, shown in **Figures 4A** and **4B****,** through 3D software for its later treatment and use in the calculation process:
   - Theoretical cylinder 400: a theoretical cylinder 400, with axis 401, is defined at the centre 402 of the arc on the section of the style line, the cylinder having a radius R_{T} equal to the radius R of the arc 403 and being its axis 401 perpendicular to the central cutting plane of the section. The length of the theoretical cylinder 400 is defined as a standard value of 3 mm. This theoretical cylinder 400 will be used to calculate the value of the real radius of the control points defined.
   - Theoretical 404 and calculation central sections: they are generated through the intersection of the central cutting plane (which is perpendicular to the curve at its defined point) with the geometry of the part 101, defining a curve length equal to 15mm on each surface tangent to the arc plus its circular sector (that is, a total length of 30mm plus the arc length 403). The same criterion is used for the calculation section but with a length of 5mm. These sections will be used to obtain the calculation parameter to be used to obtain the search field of the real cylinder.

The central section is the section used to understand the surrounding of the surfaces tangent to the style line, besides being able to obtain therefrom the parameter needed for the later radius calculation. This section must only be used on a manual calculation process.

The calculation section is defined in the same way as the previous one, but with a different dimension, as it is exclusively used for obtaining the calculation parameter and will be used on a calculation process using automated software (machine programming for automated calculation).
- Theoretical auxiliary 405 or complementary sections: they are also generated by the intersection of planes and geometry, with the specific characteristic that the perpendicular cutting planes are created at 1.5mm at each side of the central cutting plane. These intersections are defined with a curve length of 7mm on the surface tangent to the arc and coinciding in their start on the tangency of the style line surface. The result is four theoretical auxiliary sections 405. These sections will be used to optimize the position of the point cloud, obtained in a later phase, on the CAD geometry.
- Theoretical points of tangency 406: they are obtained from the intersection of the central cutting plane used to create the theoretical central section 404 and the limits of the surfaces (S1, S2) tangent to the style line. These points indicate the length (L) of the arc chord 407 as well as the position of the tangencies.
- Theoretical middle point 408 of the chord; it is the middle point of the points of tangency. The position of the circular sector is obtained.
- Theoretical middle point 409 of the arc: it is the central point of the arc 403 or maximum point of the peak of the style line. The position of the peak of the arc is obtained, thus being possible to observe the differences vis-à-vis the middle point of the arc.

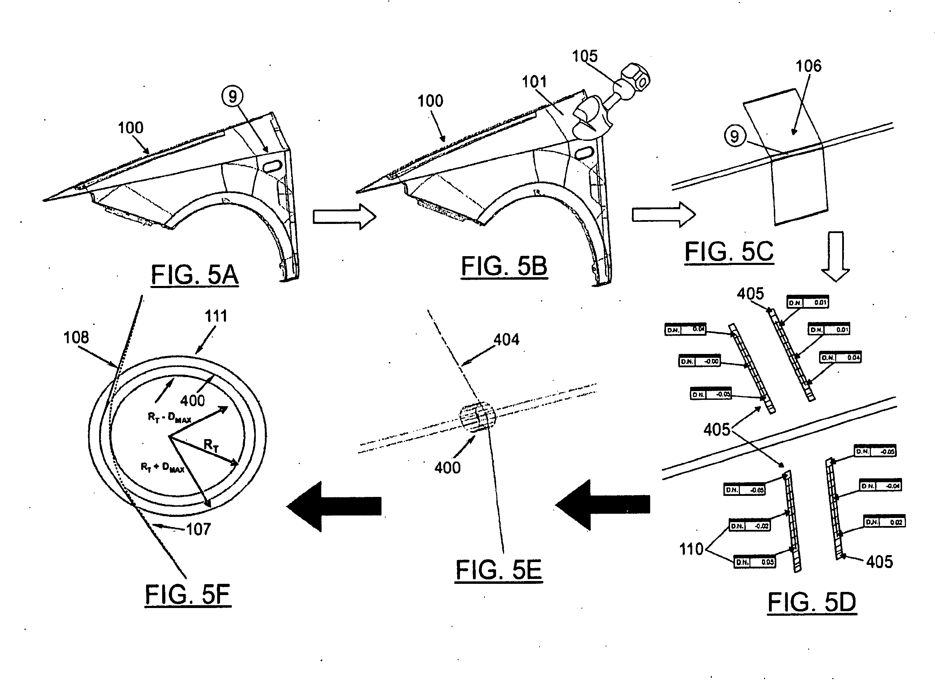

The second relative stage of the measuring process at the control points, shown in **Figures 5A, 5B, 5C, 5D, 5E** and **5F****,** comprises obtaining the point cloud 106 using coordinates measuring machines 105 (CMM). Performed with a laser scanner (contactless optical sensor based on the triangulation with structured laser light), the three-dimensional geometrical characteristics of the vehicle component is obtained at the points of interest, control points (that is, a scanning of the geometry of the real part). Figures 5A, 5B and 5C show the obtaining of the point cloud or set of points 106 around the control point number 9.

The third stage relating to the position and radius calculation process comprises:
- Treatment of the alignments of the measuring process: Work starts with the vehicle alignment, whose origin "0" is approximately at the centre of the differential. According to the area or element to be controlled (door, bumper, hood...), a RPS (Reference Position System) alignment thereof is created. Later, the cloud for each point will be optimized.
- Calculation process:
   1. Calculation of auxiliary or complementary sections: Once the point cloud 106 is obtained, the density of which will depend on the scanning speed and the parameterised step, a series of points are obtained from it projected on CAD geometry. Each group of points projected on the CAD geometry will form one of the auxiliary or complementary sections. These sections are obtained through the calculation made by the measuring software. The projected points are calculated with a 0.5mm increment between them and show the deviations 110 existing between the point cloud (real geometry 107) and the CAD geometry (theoretical geometry 108). From the cloud point, the points contained in each search field of the element are used. The 0.5mm increment is defined to extract only a limited number of points from all those contained in the cloud.
   2. Point cloud optimization: In order to place the point cloud in the best possible position with respect to the CAD geometry and eliminate possible calculation errors, an optimization of the position thereof is carried out. It is carried out unlocking degrees of freedom depending on the angle formed by the cylinder axis and the reference axes (Y, Z) of the vehicle. For example, the cylinder axis angle is 90° with respect to axes Y-Z. The characteristics of the optimization will be to allow translations in the calculation on axes Y-Z and rotation around axis X.
   3. Calculation of central and calculation sections: Once the aforementioned optimization has been performed, the deviations of the central and calculation sections are calculated, obtaining their points compared on CAD data and with a 0.1mm increment between them. From the point cloud, the points contained in each search field of the element are used and this process is an internal process of the measuring software. The 0.5mm increment is defined to extract only a limited number of points from all those contained in the cloud. Such a reduced increment is defined to obtain the greatest number of points within the surface of the style line, whose width ranges between approximately 1mm and 4mm. The theoretical dimensional characteristics of the surface of the style line, such as its width, are defined by the project and they are unalterable values.
   4. Search field determination 111: After calculation of the aforementioned sections, the absolute values of the deviations of the calculation section points are calculated, both positive and negative values, and the search parameter D_{MAX} is created which will be the highest of the aforementioned values, that is, D_{MAX} is the highest deviations produced, in absolute value. Where R_{T} is the radius of the theoretical cylinder, the search field 111 of the real cylinder is determined between a cylinder with a radius R_{T} - D_{MAX} and a cylinder with a radius R_{T} + D_{MAX}.
   5. Calculation of the real cylinder: Once the maximum deviation of the calculation section has been obtained, it shall be used to calculate the radius of the real cylinder. This maximum deviation will be the search which we will apply to the cylinder, so that within this search field 111 all points of the cloud which are within it will be captured and the real cylinder will be built with them, the radius value of said cylinder being compared to the theoretical value, thus attaining a radius deviation.
   6. Calculation of real points of tangency: Once the real cylinder has been calculated, we will also have all the points of the cloud used for building it. From them, the ends in the direction of the imaginary theoretical line will be extracted, which would form the points of tangency. In other words, those points from the ones used in the cylinder calculation which are furthest away from one another in the direction described above. These points are considered tangencies and are compared on their theoretical value, thus obtaining their dispersions.
   7. Calculation of the real middle point of the chord: With the middle point of those already obtained, the position of the string sector of each circular segment is attained.
   8. Calculation of the real middle point of the arc (peak): In order to calculate the middle point of the arc, a point of the cloud is compared on the auxiliary CAD geometry created before. This point is defined in the end point of the surface (peak).

With this information we can determine if the peak of the circular segment corresponds to the position of the sector (middle point of the string), or if there exists within the segment a deformation thereof.

## Claims

1. Control procedure of style lines of motor vehicle components, **characterized in that** it comprises:
- selecting, in a style line of a vehicle component (101) at least one control point;
- in a 3D CAD model of the vehicle component (101), for each control point, selecting the geometry of the component (101) with a perpendicular central cutting plane in the control point and obtaining the centre (402) of the arc (403) of the component which goes through the control point and its radius of curvature R;
- in a 3D CAD model of the vehicle component (101), creating an auxiliary geometry comprising, for each control point, obtaining:
• a theoretical cylinder (400) centred in the arc centre, with its axis perpendicular to the central cutting plane and with a radius of curvature R_{T} equal to the radius R of the arc (403);
• a theoretical central section (404) generated by the intersection of the central cutting plane with the geometry of the component (101);
• two theoretical auxiliary sections (405) generated by the intersection of two cutting planes parallel to the central cutting plane, and located at each side thereof at a particular distance, with the geometry of the component (101);
• theoretical points of tangency (406) as the ends of the arc (403) forming part of the theoretical central section (404);
- making a three-dimensional scanning of the component (101) around each control point, obtaining a set of measuring points (106) representing the three-dimensional geometrical characteristics of the component (101);
- calculating the existing deviations (110) between the auxiliary sections of the real geometry (107), said real geometry (107) being obtained from the set of measuring points (106), and the theoretical auxiliary sections (405);
- calculating the existing deviations between the central section of the real geometry (107), said real geometry (107) being obtained from the set of measuring points (106) and the theoretical central section (404);
- determining, from the previously-obtained deviations, a search field (111) in which the search for a real cylinder will be performed;
- obtaining, from the set of measuring points (106) within the search field, the real cylinder and the deviation of its radius vis-à-vis the radius R_{T} of the theoretical cylinder (400);
- obtaining, from the real cylinder and the set of measuring points (106), the real points of tangency and the deviation thereof vis-à-vis the theoretical points of tangency (406).

2. Control procedure according to claim 1, additionally comprising:
- in the 3D CAD model of the vehicle, obtaining for each control point:
• a theoretical middle point (408) of the chord (407) of the arc (403), being the middle point of the theoretical points of tangency (406);
• a theoretical middle point (409) of the arc; being the central point of the arc (403);
- obtaining, from the real points of tangency, the real middle point of the chord;
- obtaining, from the real cylinder and the set of measuring points (106), the real middle point of the arc and the deviation thereof vis-à-vis the theoretical middle point (409).

3. Control procedure according to any of the preceding claims, wherein the three-dimensional scanning of the component (101) is performed by means of a laser scanner (105).

4. Control procedure according to any of the preceding claims, wherein the search field (111) is determined as a cylindrical volume defined between a cylinder with a radius R_{T}-D_{MAX} and a cylinder with radius R_{T}+D_{MAX} with their respective axes coinciding with the axis of the theoretical cylinder (400), where D_{MAX} is the greatest deviation in absolute value produced between the central section of the real geometry (107) and the theoretical central section (404).

5. Control procedure according to any of the preceding claims, additionally comprising an optimization stage of the set of measuring points (106), in which said set of points is placed in an optimal position with respect to the geometry of the 3D CAD model of the vehicle through the unlocking of degrees of freedom according to the angle formed by the cylinder axis and the reference axes of the vehicle.

6. Control procedure according to any of the preceding claims, wherein the vehicle component (101) is selected between the following: a bodywork element (100); an interior vehicle component.

## Patentansprüche

1. Kontrollverfahren für Stillinien von Motorfahrzeugkomponenten, **dadurch gekennzeichnet, dass** es Folgendes umfasst:
- das Auswählen, in einer Stillinie einer Fahrzeugkomponente (101), zumindest eines Kontrollpunkts;
- in einem 3D CAD-Modell der Fahrzeugkomponente (101), für jeden Kontrollpunkt, das Auswählen der Geometrie der Komponente (101) mit einer senkrechten zentralen Schnittebene in dem Kontrollpunkt und das Erhalten der Mitte (402) des Bogens (403) der Komponente, welche durch den Kontrollpunkt hindurchgeht, und dessen Krümmungsradius R;
- in einem 3D CAD-Modell der Fahrzeugkomponente (101), das Erstellen einer Hilfsgeometrie welche, für jeden Kontrollpunkt, das Erhalten:
• eines theoretischen Zylinders (400), in der Bogenmitte zentriert, mit seiner Achse senkrecht zur zentralen Schnittebene und mit einem Krümmungsradius R_{T} der dem Radius R des Bogens (403) gleich ist;
• eines theoretischen zentralen Abschnitts (404), erzeugt durch die Überschneidung der zentralen Schnittebene mit der Geometrie der Komponente (101);
• zwei theoretischer Hilfsabschnitte (405), erzeugt durch die Überschneidung von zwei zur zentralen Schnittebene parallelen Schnittebenen, und auf jeder Seite derselben mit einem bestimmten Abstand in Bezug auf die Geometrie der Komponente (101) angeordnet;
• theoretischer Tangentialpunkte (406), als Enden des Bogens (403), welcher Teil des theoretischen zentralen Abschnitts (404) ist;
umfasst;
- das Durchführen eines dreidimensionalen Abtastens der Komponente (101) um jeden Kontrollpunkt herum, unter Erhaltung eines Satzes von Messpunkten (106), welche die dreidimensionale geometrische Merkmale der Komponente (101) darstellen;
- das Berechnen der existierenden Abweichungen (110) zwischen den Hilfsabschnitten der wirklichen Geometrie (107), wobei die genannte wirkliche Geometrie (107) aus dem Satz von Messpunkten (106) erhalten wird, und den theoretischen Hilfsabschnitten (405);
- das Berechnen der existierenden Abweichungen zwischen dem zentralen Abschnitt der wirklichen Geometrie (107), wobei die genannte wirkliche Geometrie (107) aus dem Satz von Messpunkten (106) erhalten wird, und dem theoretischen zentralen Abschnitt (404);
- das Bestimmen, aus den zuvor erhaltenen Abweichungen, eines Suchfeldes (111), in welchem die Suche nach einem wirklichen Zylinder durchgeführt werden wird;
- das Erhalten, aus dem Satz von Messpunkten (106) innerhalb des Suchfeldes, des wirklichen Zylinders und der Abweichung seines Radius in Bezug auf den Radius R_{T} des theoretischen Zylinders (400);
- das Erhalten, aus dem wirklichen Zylinder und dem Satz von Messpunkten (106), der wirklichen Tangentialpunkte und der Abweichung derselben in Bezug auf die theoretischen Tangentialpunkte (406).

2. Kontrollverfahren nach Anspruch 1, welches zusätzlich Folgendes umfasst:
- im 3D CAD-Modell des Fahrzeugs, das Erhalten für jeden Kontrollpunkt:
• eines theoretischen Zentralpunktes (408) der Sehne (407) des Bogens (403), welcher der Zentralpunkt der theoretischen Tangentialpunkte (406) ist;
• eines theoretischen Zentralpunktes (409) des Bogens; welcher der Mittelpunkt des Bogens (403) ist;
- das Erhalten, aus den wirklichen Tangentialpunkten, des wirklichen Zentralpunktes der Sehne;
- das Erhalten, aus dem wirklichen Zylinder und dem Satz von Messpunkten (106), des wirklichen Zentralpunktes des Bogens und der Abweichung desselben in Bezug auf den theoretischen Zentralpunkt (409).

3. Kontrollverfahren nach einem der vorhergehenden Ansprüche, wobei das dreidimensionale Abtasten der Komponente (101) mittels eines Laserabtasters (105) durchgeführt wird.

4. Kontrollverfahren nach einem der vorhergehenden Ansprüche, wobei das Suchfeld (111) als ein zylindrisches Volumen bestimmt wird, welches zwischen einem Zylinder mit einem Radius R_{T}-D_{MAX} und einem Zylinder mit einem Radius R_{T}+D_{MAX}, in Übereinstimmung deren jeweiligen Achsen mit der Achse des theoretischen Zylinders (400), definiert ist, wobei D_{MAX} die größte Abweichung im Absolutwert ist, die zwischen dem mittleren Abschnitt der wirklichen Geometrie (107) und dem theoretischen zentralen Abschnitt (404) vorkommt.

5. Kontrollverfahren nach einem der vorhergehenden Ansprüche, welches zusätzlich einen Optimierungsschritt des Satzes von Messpunkten (106) umfasst, in welchem der genannte Satz von Punkten in einer optimalen Stellung in Bezug auf die Geometrie des 3D CAD-Modells des Fahrzeugs gestellt wird, durch die Entsperrung der Freiheitsgrade gemäß dem durch die Zylinderachse und die Referenzachsen des Fahrzeugs gebildeten Winkel.

6. Kontrollverfahren nach einem der vorhergehenden Ansprüche, wobei die Fahrzeugkomponente (101) aus Folgenden gewählt wird: einem Karosserieelement (100); einer Fahrzeuginnenraumkomponente.

## Revendications

1. Procédé de contrôle des lignes de style de composants de véhicule à moteur, **caractérisé en ce qu'**il comprend :
- la sélection, dans une ligne de style d'un composant de véhicule (10) d'au moins un point de contrôle ;
- dans un modèle CAD 3D du composant de véhicule (101), pour chaque point de contrôle, la sélection de la géométrie du composant (101) avec un plan de coupe central perpendiculaire dans le point de control et l'obtention du centre (402) de l'arc (403) du composant qui passe à travers le point de contrôle et son rayon de courbure R ;
- dans un modèle CAD 3D du composant de véhicule (101), la création d'une géométrie auxiliaire comprenant, pour chaque point de contrôle, l'obtention de :
• un cylindre théorique (400) centré dans le centre de l'arc, avec son axe perpendiculaire au plan de coupe central et avec un rayon de courbure R_{T} égal au rayon R de l'arc (403) ;
• une section centrale théorique (404) générée par l'intersection du plan de coupe central avec la géométrie du composant (101) ;
• deux sections auxiliaires théoriques (405) générées par l'intersection de deux plans de coupe parallèles au plan de coupe central, et situés de chaque côté de celui-ci à une distance particulière, avec la géométrie du composant (101) ;
• des points théoriques de tangence (406) comme les extrémités de l'arc (403) faisant partie de la section centrale théorique (404) ;
- la réalisation d'un scannage tridimensionnel du composant (101) autour de chaque point de control, en obtenant un ensemble de points de mesure (106) représentant les caractéristiques géométriques tridimensionnelles du composant (101) ;
- le calcul des écarts existants (110) entre les sections auxiliaires de la géométrie réelle (107), ladite géométrie réelle (107) étant obtenue à partir de l'ensemble de points de mesure (106), et les sections auxiliaires théoriques (405) ;
- le calcul des écarts existants entre la section centrale de la géométrie réelle (107), ladite géométrie réelle (107) étant obtenue à partir de l'ensemble de points de mesure (106) et la section centrale théorique (404) ;
- la détermination, à partir des écarts préalablement obtenus, d'un champ de recherche (111) dans lequel la recherche d'un cylindre réel sera réalisée ;
- l'obtention, à partir de l'ensemble de points de mesure (106) dans le champ de recherche, du cylindre réel y l'écart de son rayon par rapport au rayon R_{T} du cylindre réel (400) ;
- l'obtention, à partir du cylindre réel et l'ensemble de points de mesure (106), des points réels de tangence et leur écart par rapport aux points théoriques de tangence (406).

2. Procédé de contrôle selon la revendication 1, comprenant en outre :
- dans le modèle CAD 3D du véhicule, l'obtention pour chaque point de contrôle de :
• un point médian (408) de la corde (407) de l'arc (403), étant le point médian des points théoriques de tangence (406) ;
• un point médian théorique (409) de l'arc, étant le point central de l'arc (403) ;
- l'obtention, à partir des points réels de tangence, le point médian réel de la corde ;
- l'obtention, à partir du cylindre réel et l'ensemble de points de mesure (106), le point médian réel de l'arc et son écart par rapport au point médian théorique (409).

3. Procédé de contrôle selon l'une quelconque des revendications précédentes, dans lequel le scannage tridimensionnel du composant (101) est réalisé au moyen d'un scanner laser (105).

4. Procédé de contrôle selon l'une quelconque des revendications précédentes, dans lequel le champ de recherche (111) est déterminé comme un volume cylindrique défini entre un cylindre avec un rayon R_{T}-D_{MAX} et un cylindre avec un rayon R_{T}+D_{MAX} avec leur axes respectifs coïncidant avec l'axe du cylindre théorique (400), où D_{MAX} est le plus grand écart dans la valeur absolue produite entre la section centrale de la géométrie réelle (107) et la section centrale théorique (404).

5. Procédé de contrôle selon l'une quelconque des revendications précédentes, comprenant en outre, une étape d'optimisation de l'ensemble de points de mesure (106), dans lequel ledit ensemble de points est mis en place dans une position optimale par rapport à la géométrie du modèle CAD 3D du véhicule à travers le déverrouillage des degrés de liberté selon l'angle formé par l'axe de cylindre et les axes de référence du véhicule.

6. Procédé de contrôle selon l'une quelconque des revendications précédentes, dans lequel le composant de véhicule (101) est sélectionné entre les suivants :
un élément de carrosserie (100) ; un composant intérieur de véhicule.
